(19) **Europäisches Patentamt**
**European Patent Office**
**Office européen des brevets**

(11) **EP 1 641 131 B1**

(12) **EUROPEAN PATENT SPECIFICATION**

(45) Date of publication and mention
of the grant of the patent:
**26.09.2007 Bulletin 2007/39**

(51) Int Cl.:
***H04B 1/04*** *(2006.01)*

(21) Application number: **04292692.3**

(22) Date of filing: **10.11.2004**

(54) **Digital sideband suppression for radio frequency (RF) modulators**

Digitale Seitenbandunterdrückung für Hochfrequenzmodulatoren

Suppression numérique de bande latérale pour modulateurs à fréquences radio

(84) Designated Contracting States:
**AT BE BG CH CY CZ DE DK EE ES FI FR GB GR HU IE IS IT LI LU MC NL PL PT RO SE SI SK TR**

(30) Priority: **24.09.2004 EP 04360087**

(43) Date of publication of application:
**29.03.2006 Bulletin 2006/13**

(73) Proprietor: **Alcatel Lucent**
**75008 Paris (FR)**

(72) Inventors:
• **Schlesinger, Heinz,**
**Dipl.-Ing. (FH)**
**74395 Mundelsheim (DE)**

• **Weiss, Ulrich,**
**Dipl.-Ing.**
**73035 Göppingen (DE)**

(74) Representative: **Schmidt, Werner Karl**
**Alcatel Lucent**
**Intellectual Property & Standards**
**70430 Stuttgart (DE)**

(56) References cited:
**EP-A- 0 658 975** **WO-A-03/043206**
**US-A1- 2003 206 600** **US-B1- 6 658 065**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

**Field of the invention**

The present invention relates to the field of telecommunication, and more particularly to advanced transmitter architectures based on I/Q signal processing:

**Background and prior art**

In the framework of wireless telecommunication and in particular digital wireless communication systems a baseband signal carrying information has to be modulated to a radio frequency (RF) band prior to broadcasting into free space. Generally, there exist various modulation techniques for modulating the baseband signal to a radio frequency (RF) signal.

On the one hand single stage modulation techniques provide a direct conversion of the baseband signal into a RF-signal by making use of highly linear and highly symmetric mixers, such as I/Q-modulators with very low phase-, amplitude - and DC offset errors. Such a single stage conversion technique demands for a high performance of a RF-mixer. Generally, without implementation of some kind of error compensating scheme these, RF-mixers only provide limited capabilities for broadband applications. Additionally, the general properties of an implemented RF-mixer may change during its expected life cycle, and may also vary with respect to changing environmental conditions, such like a temperature shift.

Multistage modulation techniques providing an analog or digital generation of an intermediate frequency signal inherently generate mirror frequencies that have to be attenuated by means of intermediate frequency or high frequency analog filters. Implementation of additional filters and a rather complex architecture of these multistage modulation solutions is disadvantageous with respect to production costs. Moreover, by generating undesired mirror frequencies that have to be filtered, an appreciable portion of energy required by the modulation process is simply wasted.

In principle, any component inherent error, in particular phase and amplitude errors, reflect in an insufficient sideband suppression of the generated RF-signal. An undesired sideband may appreciably spoil the transmission spectrum of a transceiver in a mobile communication network system. Sidebands that evolve in a transmission spectrum due to an amplitude errors can be effectively eliminated with commercially available digital analog converters, such like AD 9777 of Analog Devices corporation. For further information refer to http://www.analog.com.

However, suppression of sidebands that are due to phase errors remains problematic. A phase error might be due to production tolerances of involved electronic components, such like an I/Q-modulator. Assuming that amplitude errors of an I/Q modulator and the input baseband signal as well as appropriate DC offset errors can be compensated, a general phase error can be split into a phase shift between real and imaginary parts of an incident I/Q signal $\phi_m$ and a phase error $\phi_c$ representing a phase error of an I/Q modulator, that might be e.g. due to manufacturing tolerances.

Performing an I/Q modulation , i.e. modulating a baseband signal with a local oscillator (LO) signal, a lower and an upper sideband are unavoidably generated symmetric to the RF- or intermediate frequency carrier frequency. When an amplitude difference between the I and Q branch, i.e. the difference in gain of a modulator for the I and Q branch, can be eliminated, one of the two sidebands, either the lower sideband or the upper sideband can be completely eliminated if the modulator inherent phase error exactly corresponds to the phase shift of the input signal, i.e. $\phi_m = \phi_c$.

Prior art document WO 03/043206 A describes an emission device for mobile telephony with a quadrature modulator for converting a complex signal of frequency f1 to an emission signal and with a compensation path for suppression of a vestigial sideband and a carrier signal. The compensation path comprises a non-linear element which produces a signal of frequency 2f1 under the influence of an undesired modulation sideband. Said document discloses tuning the phase in order to minimize the signal component of frequency 2f1. To this end, the phases in the I and Q branches of the quadrature modulator are tuned in reciprocal fashion.

Prior art document US 6,658,065 B1 discloses a system and a method for suppressing an unwanted sideband in the output of a transmitter comprising a quadrature modulator. To this end, the I and Q components of a baseband signal are fed to a modulator, the output of which is provided to a circuit for generating a transmission signal. Said circuit is connected with a sideband detector for detecting the unwanted sideband signal. The detection signal is then used to achieve a tuning of parameters for to adapt the I and Q component signals by means of a baseband correction circuit. Said parameters may include a relative phase between the I and Q component signals.

The present invention therefore aims to provide an improved and efficient suppression of a sideband of a modulator output by making use of a phase adjustment.

**Summary of the invention**

The present invention provides a method for digital sideband suppression for radio frequency modulators.

Embodiments of the invention are described by the independent claims and the dependent claims describe preferred embodiments.

The present invention provides a method of adjusting the phase of an I/Q modulator's complex input signal for optimizing a sideband suppression of the I/Q modulator's output signal. In a first step the baseband signal is modulated to an intermediate frequency signal by means of a first and a second modulator that are adapted to convert the real and imaginary branch of the initial I/Q signal. For instance, the first modulator provides modulation of the input I/Q signal to the real branch I' of the intermediate frequency signal and the second modulator provides the corresponding imaginary branch Q' by making use of the same branches I and Q of the baseband input signal. These first and second modulators therefore allow to manually adjust the phase of the generated intermediate frequency signal with respect to the phase of the baseband input signal. Hence, either the phase of the I' or Q' branch of the intermediate frequency signal can be modified.

Preferably, the baseband signal is converted to an intermediate frequency signal with a higher carrier frequency. However, this conversion does not necessarily have to provide a signal with a higher frequency. In a special case, the frequency of the intermediate frequency signal and the frequency of the baseband signal may be equal, which corresponds to an intermediate frequency of zero. Hence, for a zero intermediate frequency the spectrum of the intermediate frequency signal remains located around zero.

The intermediate frequency signal generated by the first and second modulators is provided as input signal to the I/Q modulator. Finally, the method provides tuning of the phase of the intermediate frequency signal in order to minimize the amplitude of one sideband of the I/Q modulator's output. Depending on the preferred transmitter configuration, the invention provides both either lower or upper sideband suppression. In principle, this allows to choose whether to attenuate the lower or the upper sideband and to adapt the I/Q modulator's output to different application scenarios either requiring upper or lower sideband suppression. Tuning of the phase of the I/Q modulator's digital input signal is typically implemented by varying the phase of either the real or imaginary branch of the intermediate frequency I/Q signal.

In particular, the digital modulation of the baseband signal to the intermediate frequency signal effectively allows to manipulate the phase of the intermediate frequency signal and hence the phase of the I/Q modulator's input signal with high accuracy. In this way an I/Q modulator inherent phase error, that might be due to manufacturing tolerances of the I/Q modulator can be dynamically compensated. Hence, the invention provides a dynamic phase tuning of the I/Q modulator's input signal for suppression of a disadvantageous and undesired sideband.

Compared to solutions known in the prior art making use of e.g. filtering of sidebands or shifting of unavoidable sidebands into a frequency band that is outside the signal transmission band, the invention effectively inhibits generation of the undesired sideband and therefore provides an effective means to save energy in the modulation process and to circumvent application of filters.

Additionally, the dynamic phase adjusting mechanism allows implementation of low cost electronic components with rather large manufacturing tolerances for realizing the I/Q modulator. By adaptively tuning the phase of the I/Q modulator's input signals, standard and low cost I/Q modulators with appreciable phase errors may even be implemented for broadband applications, such as applications in the framework of wideband and multi-band transceivers, e.g. universal mobile telecommunication systems (UMTS) transceivers.

In typical implementations of the invention, the first digital modulator receives I - and Q branch of the baseband signal and generates the I' input branch for the I/Q modulator and the second digital modulator generates a signal for the Q' input branch of the I/Q modulator by making use of both I and Q branch of the baseband signal.

According to a further preferred embodiment of the invention, the first and second modulators are implemented as first and second Coordinate Rotation Digital Computer (CORDIC) modules. These first and second CORDIC modules provide multiplication of an input signal with a trigonometric function, like sine or cosine. The basic idea of a CORDIC module is based on an iterative algorithm that provides rotation of the phase of a complex number by multiplication with a succession of constant values. These multiplies can all be powers of two, so in binary arithmetic they can be done using just shifts and adds; no actual hardware multiplication is required.

This CORDIC approach is of particular advantage when hardware multipliers are not available, such as e.g. in a micro-controller or when appropriate gates of a Field Programmable Gate Array (FPGA) shall be saved for other applications.

Additionally, CORDIC based modules may calculate the trigonometric functions to any desired precision when appropriately driven. In this way the phase of the intermediate frequency signal can be manipulated with respect to any desired accuracy.

According to a further preferred embodiment of the invention, the first and second CORDIC modules are driven by a phase accumulator that is adapted to generate a driving signal at the intermediate frequency with a tuneable phase. Here, an input word of the phase accumulator with arbitrary length controls the frequency of a generated sine wave. The phase of the generated wave is governed by the modulo $2\pi$. This allows for a high precision tuning of the phase of the output signals of the CORDIC modules and hence of the input signals of the I/Q modulator. The frequency of the driving signal is typically in the range of several MHz; hence it can be generated by means of digital signal processing.

According to a further preferred embodiment of the invention, the first and second modulators are driven by a numeric controlled oscillator (NCO) that is adapted to generate a driving signal at the intermediate frequency with a tuneable phase. For example, the NCO module provides a sine and a cosine oscillation as input signal for the modulator. The modulator in turn provides multiplication of the NCO input signal with the I and Q component of the baseband signal. Preferably, the NCO provides a first input signal for the first modulator and a second input signal for the second modulator. Either one of the first or second input signals can be subject to a phase manipulation.

The tuning of the phase of the complex intermediate frequency signal may further comprise determining the amplitude of the sideband of the output signal of the I/Q modulator and using the determined amplitude as a feedback signal for manipulating the phase of the intermediate frequency signal. In this way by processing of the feedback signal, the phase of the I/Q modulator's input signal can be appropriately modified in order to almost completely eliminate an undesired sideband of the I/Q modulator's high frequency output.

The tuning of the phase of the intermediate frequency signal can also be realized by modifying the phase of the intermediate frequency signal by means of a predefined value that in turn depends on the frequency of the intermediate frequency signal or on the frequency band of the I/Q modulator. The predefined values may be stored in a table and may specify a frequency band specific phase error or phase offset of the I/Q modulator. However, this requires determination of the I/Q modulator's phase error properties prior to generation of the respective table and hence prior to performing the inventive sideband suppression procedure.

In contrast to a tuning of the phase of the intermediate frequency signal by means of a feedback signal, modification of the phase by means of predefined values does not require determination of the sideband amplitude of the output signal and subsequent signal processing.

Phase modification of the I/Q modulator's input signal by means of a look-up table may provide sufficient sideband suppression with respect to well characterized phase shifting behavior of the I/Q modulator. It therefore represents a cost efficient way of sideband suppression since it does not require an adaptive feedback loop. However, measuring of the sideband amplitude for generating a feedback signal for phase tuning generally represents a more sophisticated approach for sideband suppression that accounts for the actual environmental conditions and the actually existing sideband amplitude.

In another aspect, the invention provides an electronic circuit that is adapted to suppress undesired sidebands of an output signal of an I/Q modulator by adjusting the relative phase of the I/Q modulator's complex input signals. The inventive electronic circuit comprises a first and a second modulator for modulating a baseband signal to an intermediate frequency signal. The electronic circuit further comprises a generator module for generating a driving signal at the intermediate frequency that is provided to the first and second modulators. The electronic circuit further has a phase module that allows for tuning of the phase of the intermediate frequency signal. By tuning of the phase of the intermediate frequency signal, which can be performed by digital signal processing means, evolution of a particular sideband in the I/Q modulator's output signal can be effectively suppressed, attenuated or even be eliminated.

Furthermore, the electronic circuit comprises a control unit that is adapted to measure and to determine the amplitude of a sideband signal of the I/Q modulator's output and to appropriately control the phase module for minimizing the sideband amplitude. In this way the phase module and the control unit effectively provide a feedback mechanism for tuning the phase of the I/Q modulator's input in such a way that the undesired or unwanted sideband of the I/Q modulator's output is effectively attenuated.

In another aspect, the invention provides a transceiver for a wireless communication network that comprises this inventive electronic circuit.

In another aspect, the invention provides a base station of a wireless communication network that comprises the transceiver making use of the electronic circuit.

In still another aspect, the invention provides a mobile station of a wireless communication network that comprises the transceiver making use of the inventive electronic circuit.

**Brief description of the drawings**

In the following preferred embodiments of the invention will be described in greater detail by making reference to the drawings in which:

Figure 1      schematically shows a block diagram of the inventive electronic circuit,

Figure2      shows a block diagram of the electronic circuit making use of CORDIC modules and a phase accumulator,

Figure 3      illustrates a block diagram of a CORDIC module and a phase accumulator.

**Detailed description**

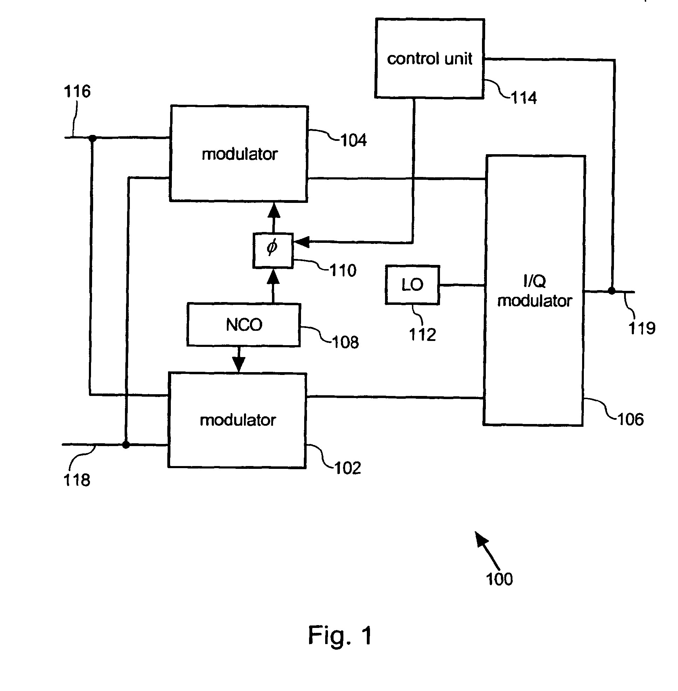

Figure 1 shows a schematic block diagram of the inventive electronic circuit 100 for suppressing a sideband of an output signal of an I/Q modulator 106. The electronic circuit 100 has modulators 102 and 104, an I/Q modulator 106, a Numeric Controlled Oscillator module 108, a phase module 110, a local oscillation generator module 112 as well as a control unit 114.

The baseband signal that has to be modulated is provided by means of the two input ports 116 and 118. The output HF signal is finally provided at the output port 119 of the I/Q modulator 106. The intermediate frequency signal is generated by means of the two modulators 104 and 102 and is provided as input to the I/Q modulator 106. For example, the real part of the baseband signal is provided by input port 116 and the imaginary part of the baseband signal is provided by the input port 118.

As can be seen in the block diagram of figure1, both real and imaginary parts, i.e. Q- and I branches of the baseband signal are provided to both modulators 102, 104. Both modulators 102, 104 can be implemented by making use of two separate multipliers and an adder. In this way modulator 104 for instance generates the real part of the modulated intermediate frequency signal and modulator 102 generates the imaginary Q part of the intermediate frequency signal.

Both modulators 102 and 104 are driven by means of the Numeric Controlled Oscillator 108. In the illustrated embodiment modulator 102 is directly driven by the NCO 108, whereas modulator 104 is driven by a corresponding signal of the NCO 108, whose phase can be shifted by means of the phase module 110. In this way the phase of the intermediate frequency signal might be arbitrarily tuned. It may therefore represent a predistorted or precompensated signal for the I/Q modulator. Preferably, modulators 102, 104, NCO 108 as well as phase module 110 are implemented by means of digital processing elements. Hence, generation of the intermediate frequency signal, which is typically in the range of several MHz, can be digitally generated and its phase can be digitally manipulated.

Real and imaginary parts of the intermediate frequency signal generated by modulators 104, 102, respectively are separately provided to the I/Q modulator 106 as input signals. The I/Q modulator 106 is typically driven by means of a local oscillator (LO) generator module 112. The two separate input signals to the I/Q modulator 106 are typically separately multiplied by orthogonal signals derived from the LO module 112. Thereafter, the two modulated signals are added and provided to the HF output 119 of the I/Q modulator 106.

The control unit 114 and the phase module 110 serve as a control loop for tuning the phase of the intermediate frequency signal. Therefore, the control unit 114 is coupled to the output of the I/Q modulator 106 in order to determine the amplitude of a sideband of the I/Q modulator's output. In response to detect an appreciable sideband amplitude, the control unit 114 is adapted to vary the phase of the intermediate frequency signal by means of controlling the phase module 110. By measuring an appropriate output signal of the I/Q modulator 106 that is based on the phase varied input signal, the sideband amplitude can be iteratively minimized or the entire sideband of the I/Q modulator's output can be completely eliminated.

The feedback loop of control unit 114 and the phase module 110 provides an efficient and accurate means to suppress sideband signals in the transmission band of the HF signal as well as a dynamic approach for compensating phase offset of an input baseband signal and phase errors of an I/Q modulator 106.

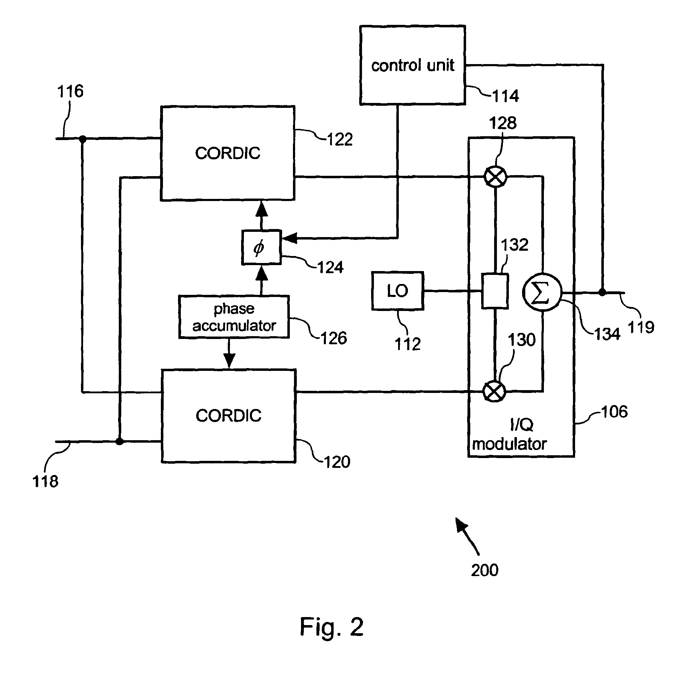

Figure 2 shows a block diagram of a preferred implementation of the electronic circuit 200 making use of two CORDIC modules 120 and 122 as substitutes for the modulators 102, 104 of the embodiment illustrated in figure 1. Additionally, compared to figure 1 also the NCO 108 is replaced by means of a phase accumulator 126. Also, the phase module 124 is adapted to be driven by the phase accumulator 126 and to provide a phase shifted driving signal to the CORDIC module 122. In this way, the phase of the signal generated by CORDIC module 122 can be effectively shifted with respect to the phase of the signal generated by CORDIC module 120.

Additionally, the internal structure of the I/Q modulator 106 is schematically shown. The I/Q modulator 106 has two multipliers 128, 130, an adder 134 as well as a splitting module 132. The high frequency signal generated by the local oscillator module 112 is provided to the splitting module 132 generating a first sinusoidal signal for the multiplier 128 and providing a 90° phase shifted signal to the multiplier 130. In this way the real part of the intermediate frequency signal provided by the CORDIC module 122 might be multiplied by a sine signal by means of the multiplier 128, whereas the complex part of the intermediate frequency signal provided by the CORDIC module 120 is multiplied by a cosine signal by means of the multiplier 130. The two evolving modulator signals are then superimposed by means of the adder 134 and are finally provided as RF signal to the output port 119 that is connected to e.g. a power amplifier of a base station for a mobile telecommunication network.

For instance assuming that the real part of the intermediate frequency signal that is provided to the multiplier 128 can be expressed by $A\cos(\omega t + \phi_m)$ and that the corresponding imaginary part equals $A\sin(\omega t)$. The two multipliers 128 and 130 of the I/Q modulator provide multiplication by $B\cos(\omega_c t + \phi_c)$ and $-B\sin(\omega_c t)$, respectively, where $\omega_c$ represents the frequency of the LO signal provided by the LO module 112, $\phi_m$ represents the phase of the intermediate frequency signal and $\phi_c$ reflects the phase offset or phase error of the I/Q modulator 106. Assuming further that the amplitudes of the real and imaginary parts as well the amplitudes of the LO signal and the incident intermediate frequency signal are all equal, the I/Q modulator's output is given by:

$$\frac{1}{2}AB\big[\cos(\omega_m t + \phi_m - (\omega_c t + \phi_c)) + \cos(\omega_m t + \phi_m + \omega_c t + \phi_c)\big]$$

$$+\frac{1}{2}AB\big[-\cos(\omega_c t - \omega_m t) + \cos(\omega_c t + \omega_m t)\big]$$

This can be expressed in term of an upper sideband (USB):

$$\frac{1}{2}AB\big[\cos(\omega_m t + \phi_m + \omega_c t + \phi_c) + \cos(\omega_c t + \omega_m t)\big]$$

and a lower sideband (LSB)

$$\frac{1}{2}AB\big[\cos(\omega_m t - \omega_c t + \phi_m - \phi_c) - \cos(\omega_m t - \omega_c t)\big].$$

As can be seen, when the two phases $\phi_m$ and $\phi_c$ are equal, hence when $\phi_m - \phi_c = 0$, then the two components of the LSB mutually compensate and the lower sideband may entirely vanish.

The control unit 114 serves to analyze the HF output signal and to generate an appropriate feedback signal for the phase module 124 as soon as an undesired sideband signal can be detected at the HF output 119.

Alternative to the illustrated embodiment, the phase module 124 might be entirely integrated into the phase accumulator 126. In contrast to the NCO module 108 of figure 1, the phase accumulator 126 provides angular values representing phase shifts with arbitrary accuracy that can be exploited by the CORDIC module in order to calculate trigonometric functions for modifying the phase of the intermediate frequency signal. For example, making use of word lengths of 16 bit, the phase can be adjusted with an accuracy of approximately 0.005°. This allows a very precise adjustment of the phase of the I/Q modulator's input. For instance, for a sideband suppression better than 60 dB, the accuracy of the phase adjustment should be below 0.1°.

The alternative embodiment illustrated in figure 1 making use of a NCO that is typically implemented by means of a look-up table, the position of phase adjustment strongly depends on the size of the look-up table. For instance, in a UMTS system with a sampling rate of 92.16 MHz and a step width of 200 kHz, at least 2,304 values have to be stored in the look-up table for having an integer number of values. Making use of 2,304 discrete values for the phase tuning, the phase can be tuned with an accuracy of 0.156°. Therefore, the CORDIC approach in combination with the phase accumulator 124 as illustrated in figure 2 represents a more accurate sideband suppression than the implementation making use of the complex modulators 102, 104 and the NCO 108. Preferably, the CORDIC module can be realized by making use of a Field Programmable Gate Array (FPGA) that provides an arbitrary choice of words of different length.

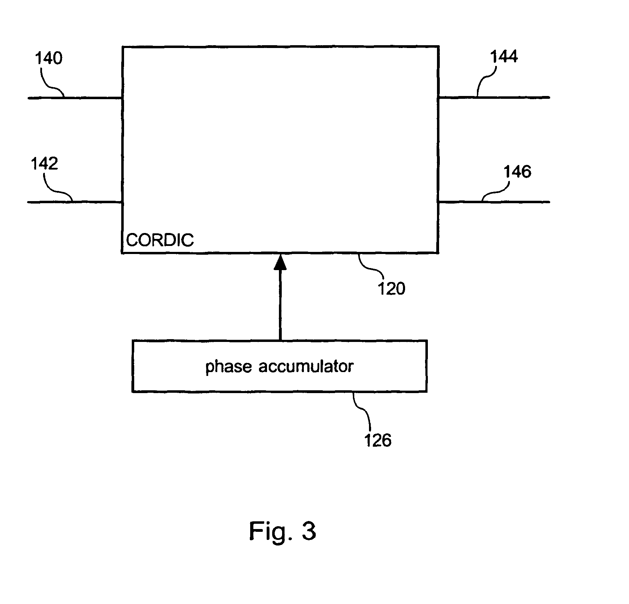

Figure 3 illustrates a block diagram of a CORDIC module 120 driven by a phase accumulator 126. The two input ports 140, 142 of the CORDIC module 120 provide real part and imaginary part of the baseband signal, respectively. The phase accumulator 126 provides a sequence of phase angles that correspond to a phase offset and that can be exploited by the CORDIC module120. Based on this phase offset, the CORDIC module 120 is adapted to modify the phase of its intermediate frequency output signal and hence to modify the respective branch of the I/Q signal.

For instance, the phase accumulator 126 provides a phase signal in terms of modulo $2\pi$ which in turn serves as a basis to generate the RF frequency signal in terms of $\omega t$. Based on the input values I at input port 140 and Q at input port 142, the CORDIC module 120 serves to multiply the complex baseband signal and to provide the imaginary part Q' of the multiplied signal at output port 144 and to provide the real part I' of the multiplied signal at output port 146.

When implementing the CORDIC module 120 into an electronic circuit 200 as illustrated in figure 2, only one of the output ports 144, 146 is coupled to only one of the input ports of the modulator 106. For instance, the imaginary output port 144 of CORDIC module 120 is coupled to the imaginary input port of I/Q modulator 106 and in a corresponding way the real output port 146 of CORDIC module 122 is coupled to the real input port of the modulator 106. Hence, the remaining ports of the two CORDIC modules 120, 122 are not coupled to the I/Q modulator 106. In this way imaginary and real part of the intermediate frequency signal are generated by means of two separate CORDIC modules 120, 122, one of which providing a phase shifted intermediate frequency signal.

**List of Reference Numerals**

| | |
|---|---|
| 100 | electronic circuit |
| 102 | modulator |
| 104 | modulator |
| 106 | I/Q modulator |
| 108 | Numeric Controlled Oscillator (NCO) |
| 110 | phase module |
| 112 | generator module |
| 114 | control unit |
| 116 | I input |
| 118 | Q input |
| 119 | RF output |
| 120 | CORDIC module |
| 122 | CORDIC module |
| 124 | phase module |
| 126 | phase accumulator |
| 128 | multiplier |
| 130 | multiplier |
| 132 | splitting module |
| 134 | adder |
| 140 | I input |
| 142 | Q input |
| 144 | Q' output |
| 146 | I' output |

**Claims**

1. A method of adjusting the relative phase of an I/Q modulator's complex input signal for attenuating a sideband of the I/Q modulator's (106) output, the method being **characterised by** the steps of:

    - modulating a baseband signal to an intermediate frequency signal by means of a first and a second modulator (102, 104),
    - providing the intermediate frequency signal as input signals to the I/Q modulator (106),
    - tuning the phase of the intermediate frequency signal in order to minimize an amplitude of a sideband of the output signal of the I/Q modulator,

    wherein said step of tuning the phase comprises modifying the phase of the intermediate frequency signal by means of a predefined value depending on the frequency of the intermediate frequency signal or on a frequency band of the I/Q modulator, said predefined values determined from the I/Q modulator's phase error properties, the I/Q modulator's phase error properties determined prior to the performance of the method.

2. The method according to claim 1, wherein the first and second modulators are implemented as a first and a second Coordinate Rotation Digital Computer (CORDIC) module (120, 122).

3. The method according to claim 2, wherein the first and second CORDIC modules are driven by a phase accumulator (126) being adapted to generate a driving signal at the intermediate frequency with a tuneable phase.

4. The method according to claim 1, wherein the first and second modulators (102, 104) are driven by a Numeric Controlled Oscillator (NCO) (108) being adapted to generate a driving signal at the intermediate frequency with a tuneable phase.

5. The method according to claim 1, wherein tuning the phase of the intermediate frequency signal further comprises:

   - determining the amplitude of the sideband of the output signal of the I/Q modulator (106) and using the determined amplitude as a feedback signal for tuning the phase of the intermediate frequency signal.

6. An electronic circuit (100; 200) being adapted to adjust the phase of an I/Q modulator's (106) complex input signal for attenuating a sideband of the I/Q modulator's output, the electronic circuit being **characterised by**:

   - a first (120) and a second (122) modulator for modulating a baseband signal to an intermediate frequency signal,
   - a generator module (126) for generating a driving signal,
   - a phase module (124) for tuning of the phase of the intermediate frequency signal by making use of the driving signal, said phase module being adapted to modify the phase of the intermediate frequency signal by means of a predefined value depending on the frequency of the intermediate frequency signal or on a frequency band of the I/Q modulator, said predefined value determined from the I/Q modulator's phase error properties, the I/Q modulator's phase error properties determined prior to the performance of the sideband suppression procedure.

7. The electronic circuit according to claim 6, wherein the first and second modulators are implemented as first and second Coordinate Rotation Digital Computer (CORDIC) modules (120, 122) and wherein the generator module is implemented by a phase accumulator (126).

8. A transceiver for a wireless communication network comprising the electronic circuit according to claim 6.

9. A base station of a wireless communication network comprising the transceiver according to claim 8.

10. A mobile station of a wireless communication network comprising the transceiver according to claim 8.


**Patentansprüche**

1. Ein Verfahren des Einstellens der relativen Phase des komplexen Eingangssignals eines I/Q-Modulators zum Dämpfen eines Seitenbandes des Ausgangs des I/Q-Modulators (106), wobei das Verfahren durch die Schritte **gekennzeichnet** ist:

   - Modulieren eines Basisbandsignals auf ein zwischenfrequenzsignal mittels eines ersten und eines zweiten Modulators (102, 104),
   - Bereitstellen des Zwischenfrequenzsignals als Eingangssignale an den I/Q-Modulator (106),
   - Abstimmen der Phase des Zwischenfrequenzsignals, um eine Amplitude eines Seitenbandes des Ausgangssignals des I/Q-Modulators zu minimieren,

   in welchem der Schritt des Abstimmens der Phase das Ändern der Phase des Zwischenfrequenzsignals mittels eines vorgegebenen Wertes in Abhängigkeit von der Frequenz des zwischenfrequenzsignals oder einem Frequenzband des I/Q-Modulators umfaßt, wobei vorgegebene Werte aus den Phasenfehlereigenschaften des I/Q-Modulators bestimmt werden, die Phasenfehlereigenschaften des I/Q-Modulators vor der Durchführung des Verfahrens bestimmt werden.

2. Das Verfahren nach Anspruch 1, in welchem der erste und zweite Modulator als ein erstes und ein zweites Coordinate Rotation Digital Computer-Modul (CORDIC-Module) (120, 122) implementiert sind.

3. Das Verfahren nach Anspruch 2, in welchem das erste und zweite CORDIC-Modul durch einen Phasenakkumulator (126) gesteuert werden, der angepaßt ist, um ein Steuersignal auf der Zwischenfrequenz mit einer abstimmbaren Phase zu erzeugen.

4. Das Verfahren nach Anspruch 1, in welchem der erste und zweite Modulator (102, 104) durch einen numerisch gesteuerten Oszillator (NCO) (108) gesteuert werden, der angepaßt ist, um ein Steuersignal auf der Zwischenfrequenz mit einer abstimmbaren Phase zu erzeugen.

5. Das Verfahren nach Anspruch 1, in welchem das Abstimmen der Phase des Zwischenfrequenzsignals außerdem umfaßt:

- Bestimmen der Amplitude des Seitenbandes des Ausgangssignals des 1/Q-Modulators (106) und Verwenden der bestimmten Amplitude als ein Rückkopplungssignal zum Abstimmen der Phase des Zwischenfrequenzsignals.

6. Eine elektronische Schaltung (100; 200), die angepaßt ist, um die Phase des komplexen Eingangssignals eines I/Q-Modulators (106) zum Dämpfen eines Seitenbandes des Ausgangs des I/Q-Modulators einzustellen, wobei die elektronische Schaltung **gekennzeichnet ist durch**:

- einen ersten (120) und einen zweiten (122) Modulator zum Modulieren eines Basisbandsignals auf ein Zwischenfrequenzsignal,
- ein Generatormodul (126) zum Erzeugen eines Steuersignals,
- ein Phasenmodul (124) zur Abstimmung der Phase des zwischenfrequenzsignals **durch** Verwendung des Steuersignals, wobei das Phasenmodul angepaßt ist, um die Phase des Zwischenfrequenzsignals mittels eines vorgegebenen Wertes in Abhängigkeit von der Frequenz des Zwischenfrequenzsignals oder eines Frequenzbandes des I/Q-Modulators zu ändern, wobei der vorgegebene Wert aus den Phasenfehlereigenschaften des 1/Q-Modulators bestimmt wird, die Phasenfehlereigenschaften des I/Q-Modulators vor der Durchführung der Seitenbandunterdrückungsprozedur bestimmt werden.

7. Die elektronische Schaltung nach Anspruch 6, in welcher der erste und zweite Modulator als erstes und zweites Coordinate Rotation Digital Computer-Modul (CORDIC-Module) (120, 122) implementiert sind und in welcher das Generatormodul durch einen Phasenakkumulator (126) implementiert ist.

8. Ein Transceiver für ein drahtloses Kommunikationsnetz, umfassend die elektronische Schaltung nach Anspruch 6.

9. Eine Basisstation für ein drahtloses Kommunikationsnetz, umfassend den Transceiver nach Anspruch 8.

10. Eine Mobilstation eines drahtlosen Kommunikationsnetzes, umfassend den Transceiver nach Anspruch 8.

## Revendications

1. Procédé permettant de régler la phase relative d'un signal d'entrée complexe du modulateur I/Q destiné à atténuer une bande latérale de la sortie du modulateur I/Q (106), le procédé étant **caractérisé par** les étapes de :

- modulation d'un signal de bande de base en un signal de fréquence intermédiaire au moyen d'un premier et d'un second modulateur (102, 104),
- fourniture du signal de fréquence intermédiaire en tant que signaux d'entrée au modulateur I/Q (106),
- réglage du signal de fréquence intermédiaire afin de réduire au maximum une amplitude d'une bande latérale du signal de sortie du modulateur I/Q,

dans lequel l'étape de réglage de phase comprend la modification de la phase du signal de fréquence intermédiaire au moyen d'une valeur prédéfinie en fonction de la fréquence du signal de fréquence intermédiaire ou d'une bande de fréquence du modulateur I/Q, lesdites valeurs prédéfinies déterminées à partir des propriétés des erreurs de phase du modulateur I/Q, les propriétés des erreurs de phase du modulateur I/Q déterminées avant l'exécution du procédé.

2. Procédé selon la revendication 1, dans lequel les premier et second modulateurs sont mis en oeuvre en tant que premier et second modules de calcul numérique par rotation de coordonnées (CORDIC) (120, 122).

3. Procédé selon la revendication 2, dans lequel les premier et second modules de CORDIC sont attaqués par un totalisateur de phases (126) adapté pour élaborer un signal d'attaque à la fréquence intermédiaire avec une phase réglable.

4. Procédé selon la revendication 1, dans lequel les premier et second modulateurs (102, 104) sont excités par un oscillateur commandé numériquement (NCO) (108) adapté pour élaborer un signal d'attaque à la fréquence intermédiaire avec une phase réglable.

5. Procédé selon la revendication 1, dans lequel le réglage de la phase du signal de fréquence intermédiaire comprend en outre:

- la détermination de l'amplitude de la bande latérale du signal de sortie du modulateur I/Q (106) et l'utilisation de l'amplitude déterminée en tant que signal de retour pour régler la phase du signal de fréquence intermédiaire.

6.  Circuit électronique (100 ; 200) adapté pour régler la phase (106) d'un signal d'entrée complexe du modulateur I/Q destiné à atténuer une bande latérale de la sortie du modulateur I/Q, le circuit électronique étant **caractérisé par** :

- un premier (120) et un second (122) modulateur destinés à moduler un signal de bande de base en un signal de fréquence intermédiaire,
- un module de générateur (126) destiné à élaborer un signal d'attaque,
- un module de phase (124) destiné à régler la phase du signal de fréquence intermédiaire en se servant du signal d'attaque, ledit module de phase étant adapté pour modifier la phase du signal de fréquence intermédiaire au moyen d'une valeur prédéterminée en fonction de la fréquence du signal de fréquence intermédiaire ou d'une bande de fréquence du modulateur I/Q, ladite valeur prédéfinie déterminée à partir des propriétés des erreurs de phase du modulateur I/Q, les propriétés des erreurs de phase du modulateur I/Q déterminées avant l'exécution de la procédure de suppression de bande latérale.

7.  Circuit électronique selon la revendication 6, dans lequel les premier et second modulateurs sont mis en oeuvre en tant que premier et second modules de calcul numérique par rotation de coordonnées (CORDIC) (120, 122) et dans lequel le module de générateur est mis en oeuvre par un totalisateur de phases (126).

8.  Emetteur-récepteur destiné à un réseau de communication sans fil comprenant le circuit électronique selon la revendication 6.

9.  Station de base d'un réseau de communication sans fil comprenant l'émetteur-récepteur selon la revendication 8.

10. Station mobile d'un réseau de communication sans fil comprenant l'émetteur-récepteur selon la revendication 8.

Fig. 1

Fig. 2

**140**

**142**

CORDIC

**120**

**144**

**146**

phase accumulator

**126**

# Fig. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03043206 A

- US 6658065 B1